# EUROPÄISCHE PATENTSCHRIFT

(11) **EP 2 452 392 B1**
(45) Veröffentlichungstag und Bekanntmachung des Hinweises auf die Patenterteilung: **21.10.2015**
(21) Anmeldenummer: 10726988.8
(22) Anmeldetag: 01.07.2010
(51) Int. Cl.: H01M 10/42, H01M 6/50, G01R 31/36

(54) **VORRICHTUNG ZUM SICHEREN TESTEN VON BATTERIEN**
DEVICE FOR SAFELY TESTING BATTERIES
DISPOSITIF SERVANT AU TEST SÉCURISÉ DE BATTERIES

(30) Priorität: 08.07.2009 DE 102009027513
(43) Veröffentlichungstag der Anmeldung: 16.05.2012
(73) Patentinhaber: Samsung SDI Co., Ltd., Gyeonggi-do (KR); Robert Bosch GmbH, 70442 Stuttgart (DE)
(72) Erfinder: DALLINGER, Frank, 70499 Stuttgart (DE); REITZLE, Alexander, 89231 Neu-Ulm (DE); KERN, Rainer, 70174 Stuttgart (DE)
(74) Vertreter: Bee, Joachim
(86) Internationale Anmeldenummer: PCT/EP2010/059338
(87) Internationale Veröffentlichungsnummer: WO 2011/003799

(56) Entgegenhaltungen:
- WO-A1-2006/088021
- DE-A1- 4 328 091
- DE-U1-202008 007 663
- US-A- 4 637 928

## Beschreibung

### Stand der Technik

Zerstörende Batterietests, beispielsweise sogenannte Abuse-Tests, werden bislang entweder im Freien oder in Testräumen durchgeführt. Dabei werden die Räume oder die Umgebung mit chemischen Stoffen und/oder Materialien kontaminiert, die schädlich, insbesondere Gesundheitsschädlich sein können. Daher müssen die Räume bislang anschließend aufwändig gereinigt werden.

Beim Versagen von Batterien, insbesondere von Lithium-Ionen Batterien, können aus dem Batterieinneren chemische Stoffe und Partikel des Elektrodenmaterials austreten. Dieses freigesetzte Material liegt dann als Partikel, Staub, Tröpfchennebel und/oder gasförmig vor und ist am Austrittsort meist sehr heiß. Dieses Material ist teilweise sehr reaktiv und gesundheitsschädlich. Das freigesetzte Material kann an umliegenden Oberflächen kondensieren und kontaminiert damit den umgebenden Bereich. Es ist auch möglich, dass sich das freigesetzte Material entzündet und es zu Brand- und/oder Explosionsereignissen kommt.

Im Regelfall wird beim Einsatz und Test von Batterien, insbesondere von Lithium-Ionen-Batterien, das Versagen der Batterien technisch unterbunden. Kommt es dennoch zu einem solchen Batterieversagen, so ist ein erheblicher Aufwand nötig zur Reinigung und Dekontamination der Umgebung der beschädigten Batterie.

Aufgabe der vorliegenden Erfindung ist es einen oder mehrere Nachteile des Standes der Technik zu vermindern oder zu vermeiden. Insbesondere ist es Aufgabe der Erfindung Mittel bereitzustellen, die es erlauben Batterietests durchzuführen, wobei die Gefährdung für Personen und Umwelt reduziert ist.

### Offenbarung der Erfindung

Die Aufgabe wird gelöst durch Bereitstellung einer Vorrichtung zum sicheren Testen von Batterien gemäß den Merkmalen des Anspruchs 1.

Werden in der Prüfkammer der erfindungsgemäßen Vorrichtung Schadstoffe aus dem Inneren einer zu testenden Batterie frei gesetzt, so werden diese erfindungsgemäß durch ein in der Prüfkammer vorhandenes Fluid gebunden. Das Fluid mit den gebundenen Schadstoffen kann dann einfach und gefahrlos entsorgt werden, so dass für Personen und Umwelt keine Gefährdung besteht und die Schadstoffe kostengünstig aus der Prüfkammer entfernt werden können.

Die erfindungsgemäße Vorrichtung ist geeignet zum sicheren Testen von Batterien. Unter einem Batterietest werden dabei alle Prüfungen und Tests verstanden, bei denen das Verhalten einer Batterie auf definierte innere oder äußere Zustände oder Zustandsänderungen der Batterie selbst, Teilen davon oder der Umgebung der Batterie beobachtet wird. Solche Tests umfassen beispielsweise Funktionstests unter unterschiedlichsten Bedingungen, Sicherheitstests, Zulassungs-relevante Tests, vom TÜV vorgeschriebene oder empfohlene Tests und sogenannte Abuse-Tests. Insbesondere handelt es sich um Batterietests, bei denen es zur Beschädigung der Batterie und damit verbunden zur Freisetzung von Schadstoffen aus der Batterie kommen kann.

Grundsätzlich eignet sich die erfindungsgemäße Vorrichtung zum Testen von Batterien jeden Typs und jeder Bauart. Unter dem Begriff "Batterie" werden hier elektrochemische Energiespeicher verstanden, insbesondere Batterien oder Akkumulatoren aller gebräuchlichen Akkumulatortechnologien. Es können Batterien oder Akkumulatoren vom Typ Pb - Bleiakku, NiCd - Nickel-Cadmium-Akku, NiH2 - Nickel-Wasserstoff-Akkumulator, NiMH - Nickel-Metallhydrid-Akkumulator, Li-Ion - Lithium-Ionen-Akku, LiPo - Lithium-Polymer-Akku, LiFe - Lithium-Metall-Akku, Li-Mn - Lithium-Mangan-Akku, LiFePO₄ - Lithium-Eisen-Phosphat-Akkumulator, LiTi - Lithium-Titanat-Akku, RAM - Rechargeable Alkaline Manganese, Ni-Fe - Nickel-Eisen-Akku, Na/NiCI - Natrium-Nickelchlorid-Hochtemperaturbatterie, SCiB - Super Charge Ion Battery, Silber-Zink-Akku, Silikon-Akku, Vanadium-Redox-Akkumulator und/oder Zink-Brom-Akku verwendet werden. Insbesondere können Batterien vom Typ der Blei/Säure-, Nickel-Cadmium-, Nickel-Metallhydrid- und/oder Natrium/Natriumnickelchlorid-Batterie eingesetzt werden. Besonders bevorzugt werden Batterien vom Typ der Lithium-Ionen-Batterie verwendet. Der Begriff "Batterie" wird dabei sowohl für einzelne Zellen, als auch für Module aus mehreren Zellen, als auch für komplexere Architekturen umfassend mehrere Zellen und/oder Module verwendet.

Bevorzugt werden hochkapazitive Batterien eingesetzt mit einer nominalen Kapazität von mindestens 3Ah. Besonders bevorzugt von 3Ah bis 300Ah, insbesondere von 4Ah bis 80Ah. Nominale Kapazitäten von Lithium-Ionen-Einzel-Zellen für PKWs oder LKWs liegen im Bereich von 3 - 300Ah und typischerweise zwischen 4 und 80 Ah. Dabei können sich die angegebenen nominalen Kapazitätswerte entweder auf die ganze intakte Batterie beziehen oder auf eine einzelne Zelle einer Batterie.

Bevorzugt sind die zu testenden Batterien teilweise oder ausschließlich Lithiumlonen- und/oder Lithium-Ionen-Polymer-Zellen, -Module und/oder -Batterien mit einer nominalen Kapazität von mindestens 3Ah pro Zelle.

Die erfindungsgemäße Vorrichtung umfasst eine Batterieprüfkammer. Eine Batterieprüfkammer ist ein abgeschlossener Raum, der Wände aus geeigneten Materialien und geeigneter Bauart aufweist und dafür ausgelegt ist eine oder mehrere der zu testenden Batterien aufzunehmen. Dazu weist die Batterieprüfkammer eine ggf. verschließbare Öffnung auf, durch die die zu testende Batterie in das Innere der Batterieprüfkammer verbracht werden kann. Im Inneren der Batterieprüfkammer befindet sich eine Aufnahme für die zu testende Batterie, auf der die Batterie ruhend positionierbar oder positioniert ist. Bei dieser Aufnahme kann es sich beispielsweise um einen Prüftisch handeln, der derart ausgeführt ist, dass die zu testende Batterie während der Durchführung des Tests darauf fixiert werden kann. Geeignete Batterieprüfkammern sind dem Fachmann bekannt. Zusätzlich kann die Batterieprüfkammer eine oder mehrere Anordnungen aufweisen, die dazu dienen können die zu testende Batterie einer Belastung auszusetzen. Dabei kann es sich beispielsweise um Anordnungen handeln zur Temperaturregulation, zur Druckregulation, zur Übermittlung einer kinetischen Energie auf die zu prüfende Batterie, zur Strom-, Spannungs- und/oder Kurzschlussregulation der zu testenden Batterie.

Die Batterieprüfkammer der erfindungsgemäßen Vorrichtung kann auch eine Sensorik zur Erfassung von Batteriezuständen aufweisen. Geeignete Sensoren und Sensortypen sind dem Fachmann bekannt und können je nach gewünschtemTest ausgewählt werden. Beispiele für geeignete Sensortypen sind:
- Temperatursensoren, die Daten über den Temperaturzustand der Batterie oder Teilen davon bereit stellen.
- Drucksensoren, die einen ggf. plötzlichen, pulsartigen Druckanstieg messen können, wie er beispielsweise bei einer Batteriebeschädigung durch einen Sturz auftreten kann.
- Gassensoren, die Daten über eine Freisetzung eines bestimmten Gases oder Gasgemisches innerhalb oder aus dem Batterieinneren ermitteln können.
- Spannungssensoren, die Daten über die Kräfteverteilung (Statik) in und/oder an der Batterie oder Teilen davon liefern.
- Elektrische Spannungssensoren, die Daten über elektrische Spannungen innerhalb der Batterie liefern können.
- Bewegungssensoren, die Daten über eine Stoßbewegung innerhalb der Batterie und/oder auf die Batterie einwirkend erfassen können.

Die erfindungsgemäße Vorrichtung weist ein oder mehrere Mittel auf zum Binden von Schadstoffen. Diese Mittel sind dabei derart ausgeführt, dass Schadstoffe, die während eines Batterietests in der Prüfkammer freigesetzt werden, durch ein Fluid gebunden werden können. Unter "gebunden" wird hierbei verstanden, dass die Schadstoffe derart in dem Fluid aufgenommen werden, dass die im Fluid gebundenen Schadstoffe im Wesentlichen nicht mehr zur Gefährdung von Personen und Umwelt beitragen. Dabei können die Schadstoffe mit dem Fluid oder mit Bestandteilen des Fluids derart chemisch reagieren, dass von den Reaktionsprodukten im Wesentlichen keine Gefährdung von Personen oder der Umgebung mehr ausgeht. Die Schadstoffe können aber auch mit anderen, aus der Batterie freigesetzten oder in der Batterieprüfkammer vorhandenen Verbindungen, katalysiert durch das Fluid oder Bestandteile davon, derart chemisch reagieren, dass von den Reaktionsprodukten im Wesentlichen keine Gefährdung von Personen oder der Umgebung mehr ausgeht.

Die Mittel zum Binden von Schadstoffen weisen ein flüssiges Fluid auf. Das Fluid hat die Eigenschaft Schadstoffe, die während eines Batterietests aus einer Batterie freigesetzt werden können, insbesondere Säuren und/oder Basen, aufzunehmen und zu binden. Besonders bevorzugt kann das Fluid Wasser enthalten oder daraus bestehen.

Das Fluid enthält mindestens ein Bindemittel oder besteht daraus welches geeignet ist Säuren und/oder Basen zu binden. Dazu kann das Fluid oder das Bindemittel selbst basische oder saure Eigenschaften aufweisen.

Je nach zu testendem Batteriematerial können bei einer Beschädigung der Batterie unterschiedliche Säuren und/oder Basen freigesetzt werden oder als Reaktionsprodukt entstehen, wenn vorher getrennte Bestandteile der Batterie nun in Kontakt treten. Daher kann die Auswahl des Fluids oder des/der Bindemittel davon abhängen, welche Batterietypen getestet werden sollen. Insbesondere bei der Testung von Lithium-Ionen-Batterien kann das Bindemittel basisch und geeignet sein, Säuren, insbesondere Flusssäure, zu binden. Es können Bindemittel verwendet werden, die geeignet sind Fluor zu binden, sogenannte Fluor-Fänger. Geeignete Bindemittel oder Säureregulatoren sind dem Fachmann bekannt. Bevorzugt kann das Fluid bzw. das Bindemittel des Fluids Kalziumoxid (CaO), Kalziumchlorid (CaCl₂) und/oder Kaliumhydroxid (Ca(OH)₂) umfassen oder daraus bestehen.

Es können auch mehr als ein Bindemittel jeweils einzeln oder als Gemisch in einem Fluid oder in mehreren verschiedenen Fluiden eingesetzt werden. Das Bindemittel, die Bindemittel oder das Bindemittelgemisch können jeweils unabhängig voneinander in fester, flüssiger und/oder gasförmiger Form im Fluid vorliegen.

Die Mittel zum Binden von Schadstoffen sind derart ausgeführt, dass das Fluid derart präsentiert wird, dass Schadstoffe, die sich im Innenraum der Batterieprüfkammer befinden, durch das Fluid gebunden werden können. Dazu ist das Mittel derart ausgestaltet, dass das Fluid direkt in Kontakt mit der zu testenden Batterie gebracht werden kann und dass das Fluid mit der Atmosphäre des Innenraums der Batterioprüfkammer direkt in Kontakt steht, so dass Schadstoffe, die sich in dieser Atmosphäre befinden mit dem Fluid kontaktierbar sind und vom Fluid gebunden werden können.

Das Mittel zum Binden von Schadstoffen umfaßt eine Sprenkleranlage umfassen oder besteht daraus. Geeignete Sprenkleranlagen sind in anderem Zusammenhang in der Literatur bereits beschrieben, z.B. im Zusammenhang von Brandschutzmassnahmen, so dass der Fachmann keine Schwierigkeiten hat, bekannte Sprenkleranlagen derart anzupassen, dass diese in der erfindungsgemäßen Vorrichtung eingesetzt werden können. Erfindungsgemäß ist die Sprenkleranlage derart ausgeführt, dass mindestens ein Teil der Fluidauslässe der Sprenkleranlage oberhalb der Aufnahme für die zu testende Batterie positioniert ist. Dies führt dazu, dass freigesetztes Fluid mit einer Oberfläche der zu testenden Batterie direkt in Kontakt gebracht werden kann.

In einer bevorzugten Ausführungsform der erfindungsgemäßen Vorrichtung ist mindestens ein Teil der Fluidauslässe des Sprenkleranlage an der Decke des Innenraumes der Batterieprüfkammer positioniert, so dass das freigesetzte Fluid einen möglichst großen Teil der Atmosphäre des Batterieprüfkammerinnenraums kontaktieren und von Schadstoffen befreien ("waschen") kann. Bevorzugt weist die Sprenkelranlage einen Fluidzulauf, einen oder mehrere Fluidauslässe und einen Fluidablass auf. Der Fluidzulauf dient dazu die Fluidauslässe mit Fluid zu versorgen, welches dann freigesetzt werden kann. Die Fluidauslässe der Sprenkleranlage dienen dazu Fluid freizusetzen und damit zur Aufnahme und Bindung von Schadstoffen bereitzustellen. Dazu weist die Sprenkleranlage bevorzugt eine Vielzahl von Fluidauslässen auf, die derart über die Oberfläche des Innenraums der Batterieprüfkammer verteilt vorliegen, dass ein möglicht großer Teil der Atmosphäre des Innenraums der Batterieprüfkammer mit freigesetztem Fluid kontaktierbar ist. Die Fluidauslässe können dabei beispielsweise mindestens teilweise als Düsen ausgebildet sein oder Düsen umfassen, die es erlauben Fluid als Sprühnebel in den Innenraum der Batterieprüfkammer freizusetzen. Die Fluidauslässe der Sprenkleranlage können beispielsweise als ggf. beweglicher oder rotierbarer Spülarm ausgebildet sein oder als stationäre Berieselungseinrichtung, über die das Fluid in Form von Tröpfchen oder Sprühnebel in den Innenraum der Batterieprüfkammer freigesetzt wird.

Im Innenraum der Batterieprüfkammer kann die erfindungsgemäße Vorrichtung eine Rückhaltewanne aufweisen. Diese Rückhaltewanne ist derart ausgestaltet, dass diese freigesetztes Fluid aufnehmen kann. Die Rückhaltewanne kann ein regel- und/oder steuerbaren Fluidablass aufweisen, über den gesammeltes, ggf. mit gebundenen Schadstoffen versehenes Fluid aus der erfindungsgemäßen Vorrichtung entfernt und ggf. einfach und sicher entsorgt werden kann.

Das Mittel zum Binden von Schadstoffen kann z.B. eine Überdruckableitung mit einer Gaswaschanordnung umfassen oder daraus bestehen. Geeignete Überdruckableitungen mit einer Gaswaschanordnung sind in anderem Zusammenhang in der Literatur bereits beschrieben, so dass der Fachmann keine Schwierigkeiten hat, bekannte Überdruckableitungen mit einer Gaswaschanordnung derart anzupassen, dass diese in der erfindungsgemäßen Vorrichtung eingesetzt werden können. Die Überdruckableitung ist dabei derart ausgeführt, dass Gasströme aus dem Inneren der Batterieprüfkammer aus der erfindungsgemäßen Vorrichtung abgeführt werden können. Solche Gasströme können beispielsweise dann entstehen, wenn aus dem Batterieinneren plötzlich Gasmengen austreten und freigesetzt werden oder wenn es im Innenraum der Batterieprüfkammer zu Explosionsereignissen und/oder aus anderen Gründen zu einem Überdruck kommt. Damit über diese Überdruckableitung nicht ungehindert Schadstoffe aus dem Inneren der Batterieprüfkammer in die Umwelt gelangen können, weist die Überdruckableitung erfindungsgemäß eine Gaswaschanordnung auf, die derart in der erfindungsgemäßen Vorrichtung positioniert ist, dass Gaströme, die den Innenraum über die Überdruckableitung verlassen zuerst durch die Gaswaschanordnung geleitet werden, bevor der Gasstrom die erfindungsgemäße Vorrichtung verlassen kann. Die Gaswaschanordnung weist ein Fluid auf, durch welches der Gasstrom derart geführt wird, dass im Gasstrom enthaltene Schadstoffe direkt mit dem Fluid in Kontakt treten können und vom Fluid gebunden werden können. Entsprechende Gaswaschanordnungen sind dem Fachmann bekannt.

Die erfindungsgemäße Vorrichtung kann mehrere gleiche oder verschiedene Mittel zum Binden von Schadstoffen aufweisen. Insbesondere kann die erfindungsgemäße Vorrichtung eine oder mehrere Wasserwandanordnungen, eine oder mehrere Sprenkleranlagen und/oder eine oder mehrere Überdruckableitungen mit einer oder mehreren Gaswaschanordnungen aufweisen.

Die erfindungsgemäße Vorrichtung kann zusätzlich Mittel aufweisen zur Regelung und/oder Steuerung der Mittel zum Binden von Schadstoffen. Beispielsweise kann die erfindungsgemäße Vorrichtung eine oder mehrere PLC-Steuerungen (PLC steht für Programable Logic Controller) aufweisen, zur Steuerung der Mittel zum Binden von Schadstoffen.

Im folgenden wird die Erfindung anhand von Ausführungsbeispielen exemplarisch näher erläutert.

### Figuren:

- FIG. 1: zeigt eine schematische Darstellung einer Ausführungsform einer Wasserwandanordnung zum Einsatz in einer nicht erfindungsgemäßen Vorrichtung.
- FIG. 2: zeigt eine schematische Darstellung einer Ausführungsform einer erfindungsgemäßen Vorrichtung mit einer Sprenkelanlage als Mittel zum Binden von Schadstoffen.
- FIG. 3: zeigt eine schematische Darstellung einer weiteren Ausführungsform einer erfindungsgemäßen Vorrichtung mit einer Wasserwandanordnung, einer Sprenkelanlage und einer Überdruckleitung mit einer Gaswaschanordnung.

### Beispiel 1:

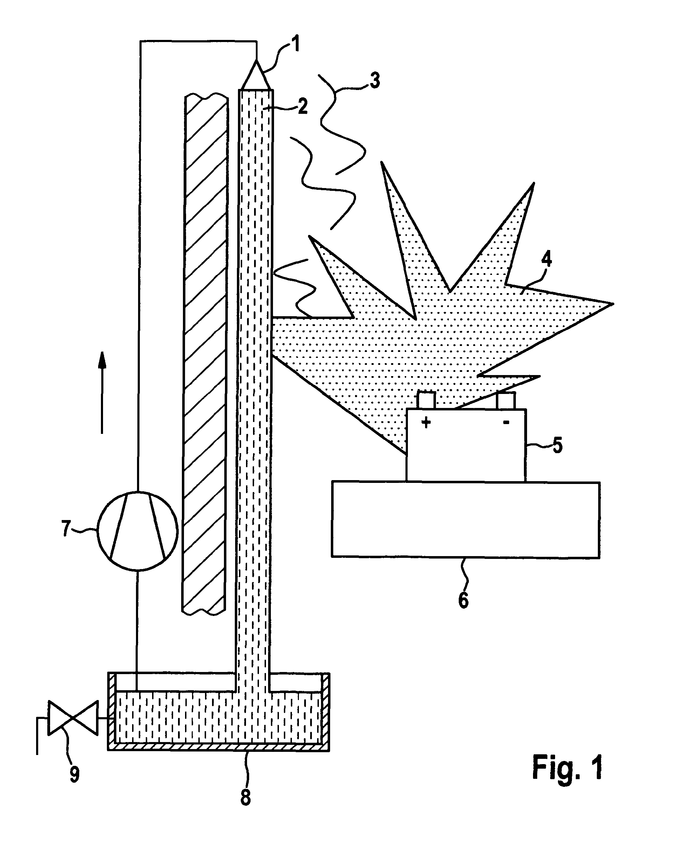

In FIG. 1 ist eine Ausführungsform einer Wasserwandanordnung zum Einsatz in einer erfindungsgemäßen Vorrichtung bzw. in einem erfindungsgemäßen Verfahren schematisch dargestellt. Die Wasserwandanordnung weist einen Fluidauslass 1 auf, welcher derart ausgestaltet ist, dass Fluid wandartig freigesetzt wird. Das wandartig freigesetzte Fluid 2 gelangt im Wesentlichen in vertikaler Richtung entlang der Schwerkraft vom Fluidauslass 1 zu einer Auffangwanne 8. Aus der Auffangwanne 8 kann das aufgefangene Fluid mittels einer Pumpe 7 wieder dem Fluidausfluss 1 zugeführt werden, so dass ein Fluidkreislauf gebildet werden kann. Die Auffangwanne 8 weist einen Fluidablass 9 auf über den aufgefangenes Fluid regel- und/oder steuerbar abgelassen und aus der Wasserwandanordnung entfernt werden kann.

Wird eine solche Wasserwandanordnung während eines zerstörenden Batterietest derart positioniert, dass partikelförmige Schadstoffe 4 und/oder gasförmige Schadstoffe 3, die aus der zu testenden Batterie 5 in ihrer Aufnahme 6 freigesetzt werden, das wandartig freigesetzte Fluid 2 kontaktieren können, so können die freigesetzten Schadstoffe effektiv vom wandartig freigesetzten Fluid 2 aufgenommen und gebunden werden. Die partikel- und/oder gasförmigen Schadstoffe 3, 4 stehen somit nicht mehr zur Verfügung, um Gefahrenquellen für Personen oder die Umwelt darzustellen.

Diese Wasserwandanordnung kann als Mittel zum Binden von Schadstoffen in einer erfindungsgemäßen Vorrichtung zum sicheren Testen von Batterien verwendet werden, sowie in einem erfindungsgemäßen Verfahren zum Binden von Schadstoffen, die während eines Batterietests aus einer Batterie freigesetzt werden.

### Beispiel 2:

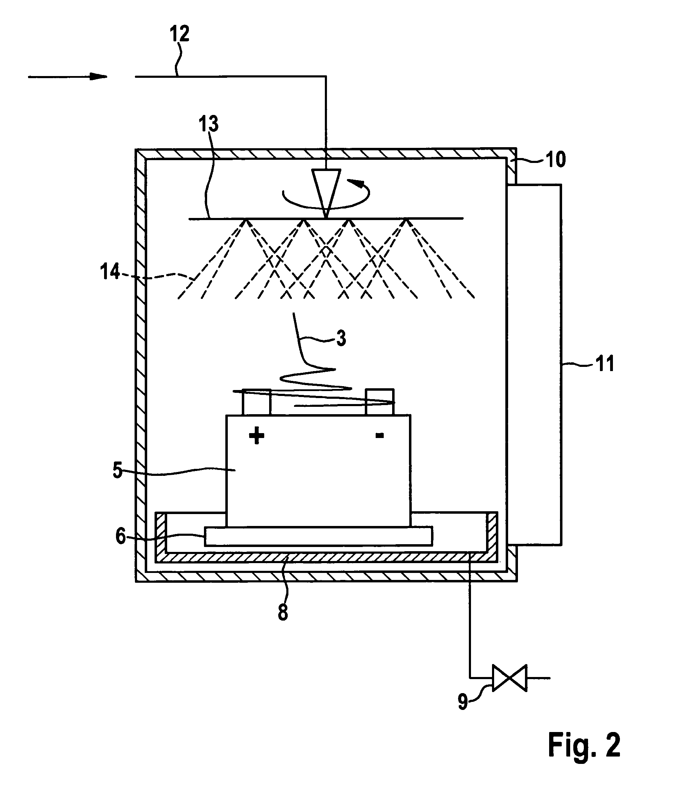

In FIG. 2 ist eine Ausführungsform einer erfindungsgemäßen Vorrichtung mit einer Sprenkelanlage als Mittel zum Binden von Schadstoffen schematisch dargestellt.

In dieser Ausführungsform der erfindungsgemäßen Vorrichtung zum sicheren Testen von Batterien ist das Mittel zum Binden von Schadstoffen als Sprenkelanlage mit einem rotierenden Spülarm 13 ausgeführt.

Die erfindungsgemäße Vorrichtung weist eine Batterieprüfkammer 10 auf, mit einer Tür 11, durch die die Batterieprüfkammer 10 mit einer zu testenden Batterie 5 be- oder entladen werden kann. Im Inneren der Batterieprüfkammer 10 ist eine Aufnahme für eine zu testende Batterie 6 und eine darauf platzierte zu testende Batterie 5 angebracht. An der Decke der Batterieprüfkammer 10 ist ein Spülarm 13 platziert, der von aussen durch einen Fluidzulauf 12 mit Fluid versorgt werden kann. Am Boden der Batterieprüfkammer 10 befindet sich eine Auffangwanne 8 mit einem regel- und/oder steuerbaren Fluidablass 9.

Wird während eines Batterietests die zu testende Batterie 5 beschädigt, so können beispielsweise gasförmige Schadstoffe 3 aus der Batterie 5 freigesetzt werden. Diese gasförmigen Schadstoffe 3 können aus der Atmosphäre des Innenraums der Batterieprüfkammer 10 entfernt werden, in dem aus dem rotierenden Spülarm 13 Fluid freigesetzt wird. Das freigesetzte Fluid 14 kann beispielsweise als Sprühnebel freigesetzt werden oder in Form von Tröpfchen. Das freigesetzte Fluid 14 gelangt nun aufgrund der Schwerkraft vom rotierenden Spülarm 13 durch den Innenraum der Batterieprüfkammer 10 in die am Boden der Batterieprüfkammer 10 befindlichen Auffangwanne 8. Dabei durchquert das freigesetzte Fluid 14 große Teile der Atmosphäre des Innenraums der Batterieprüfkammer 10, kommt dabei mit den gasförmigen Schadstoffen 3 direkt in Kontakt, kann diese aufnehmen, binden und dabei effektiv aus der Atmosphäre des Innenraums der Batterieprüfkammer 10 entfernen (oder "waschen"). Das mit gebundenen Schadstoffen belastete Fluid sammelt sich in der Auffangwanne 8 und kann bei Bedarf über den Fluidablass 9 aus der erfindungsgemäßen Vorrichtung entfernt und anschließend sicher und bequem entsorgt werden. Die beim Test freigesetzten Schadstoffe aus der zu testenden Batterie 5 können so entfernt werden, ohne dass die Batterieprüfkammer 10 geöffnet werden muss, so dass keine Gefährdung für Personen oder die Umwelt entsteht.

### Beispiel 3:

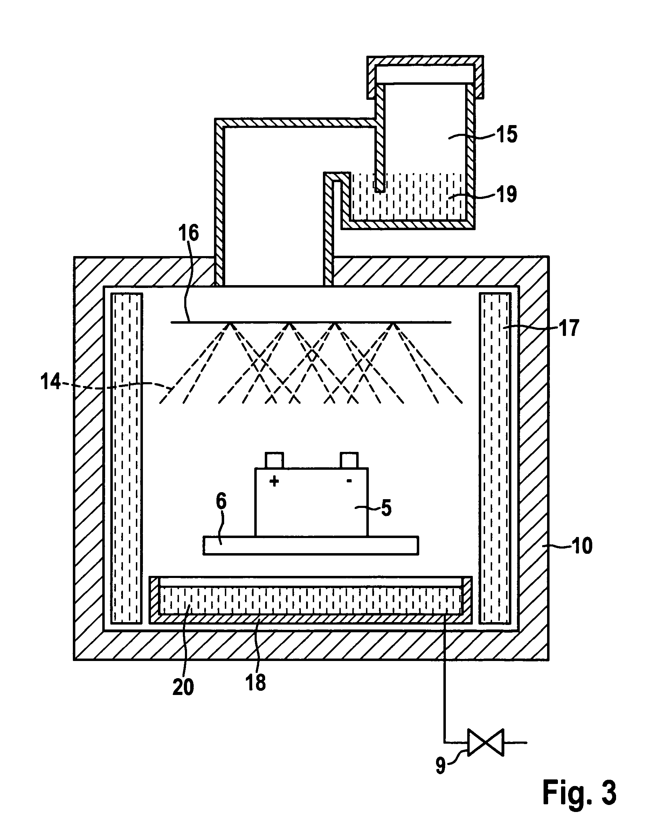

In FIG. 3 ist eine schematische Darstellung einer weiteren Ausführungsform einer erfindungsgemäßen Vorrichtung mit einer Wasserwandanordnung, einer Sprenkelanlage und einer Überdruckleitung mit einer Gaswaschanordnung gezeigt.

In dieser Ausführungsform der erfindungsgemäßen Vorrichtung zum sicheren Testen von Batterien sind mehrere verschiedne Mittel zum Binden von Schadstoffen angeordnet, sowohl mehrere Wasserwandanordnungen, als auch eine Sprenkelanlage und eine Überdruckableitung mit einer Gaswaschanordnung. Dier erfindungsgemäße Vorrichtung weist eine Batterieprüfkammer 10 auf, in der eine Aufnahme 6 für die zu testende Batterie einschließlich einer zu testenden Batterie 5 angeordnet ist. An den Innenseiten der Seitenwände der Batterieprüfkammer 10 sind Wasserwandanordnungen 17 derart platziert, dass sich zwischen dem wandartig freigesetzten Fluid und der zu testenden Batterie 5 keine störenden Gegenstände befinden, die einen direkten Zugang der freigesetzten Schadstoffe aus der zu testenden Batterie 5 zum wandartig freigesetzten Fluid der Wasserwandanordnungen 17 behindern. Am Boden der Batterieprüfkammer 10 ist eine Rückhaltewanne 18 platziert, die über einen regel- und/oder steuerbaren Fluidablass 9 verfügt. An der Decke der Batterieprüfkammer 10 ist eine Sprenkelanlage in Form einer Berieselung 16 angebracht. Des weiteren ist in die Decke der Batterieprüfkammer eine Überdruckableitung mit Gaswaschanordnung 15 eingelassen.

Wird während eines Batterietests die zu testende Batterie 5 beschädigt, so können Schadstoffe aus der Batterie 5 freigesetzt werden. Diese Schadstoffe können aus der Atmosphäre des Innenraums der Batterieprüfkammer 10 entfernt werden, in dem:
- aus der Berieselung 16 Fluid freigesetzt wird. Das freigesetzte Fluid 14 kann beispielsweise als Sprühnebel freigesetzt werden oder in Form von Tröpfchen. Das freigesetzte Fluid 14 gelangt nun im Wesentlichen aufgrund der Schwerkraft von der Berieselung 16 durch den Innenraum der Batterieprüfkammer 10 in die am Boden der Batterieprüfkammer 10 befindlichen Rückhaltewanne 18. Dabei durchquert das freigesetzte Fluid 14 große Teile der Atmosphäre des Innenraums der Batterieprüfkammer 10, kommt dabei mit den freigesetzten Schadstoffen direkt in Kontakt, kann diese aufnehmen, binden und dabei effektiv aus der Atmosphäre des Innenraums der Batterieprüfkammer 10 entfernen (oder "waschen"). Das mit gebundenen Schadstoffen belastete Fluid 20 sammelt sich in der Rückhaltewanne 18 und kann bei Bedarf über den Fluidablass 9 aus der erfindungsgemäßen Vorrichtung entfernt und anschließennd sicher und bequem entsorgt werden.
- Schadstoffe mit dem wandartig freigesetzten Fluid der Wasserwandanordnungen 17 direkt in Kontakt kommen. Die Schadstoffe werden dann vom wandartig freigesetzten Fluid aufgenommen und gebunden. Das mit gebundenen Schadstoffen belastete Fluid der Wasserwandanordnungen 17 gelangt dann in Auffangwannen der Wasserwandanordnungen 17 und kann entweder wiederverwendet werden oder sicher und bequem aus der erfindungsgemäßen Vorrichtung entfernt und entsorgt werden.
- Schadstoffe mit einem Gasstrom aus dem Innenraum der Batterieprüfkammer 10 in eine Überdruckableitung mit Gaswaschanordnung 15 gelangen. Dabei ist die Überdruckableitung mit Gaswaschanordnung 15 derart ausgeführt, dass ein Gasstrom der aus dem Inneren der Batterieprüfkammer 10 aus der erfindungsgemäßen Vorrichtung heraus geleitet wird, unvermeidlich durch eine Gaswaschanordnung enthaltend ein Fluid 19 zum Binden von Schadstoffen geführt wird. Dort kommen die im Gasstrom enthaltenden Schadstoffe direkt mit dem Fluid der Gaswaschanordnung 19 in Kontakt, werden von diesem aufgenommen und gebunden. Der aus der erfindungegemäßen Vorrichtung entweichende Gasstrom ist somit abgereichert für Schadstoffe, die während des Batterietests freigesetzt worden sind.

Die beim Test freigesetzten Schadstoffe aus der zu testenden Batterie 5 können so effektiv entfernt werden ohne dass die Batterieprüfkammer 10 geöffnet werden muss, so dass keine Gefährdung für Personen oder die Umwelt entsteht.

## Patentansprüche

1. Vorrichtung zum sicheren Testen von Batterien, umfassend eine Batterieprüfkammer mit einem Innenraum enthaltend eine Aufnahme für die zu testende Batterie, wobei die Vorrichtung mindestens ein Mittel zum Binden von Schadstoffen aufweist, welches derart ausgeführt ist, dass Schadstoffe, die während eines Batterietests in der Batterieprüfkammer freigesetzt werden, durch ein Fluid bindbar sind,
**dadurch gekennzeichnet, dass**
das Mittel zum Binden von Schadstoffen eine Sprenkleranlage umfasst oder daraus besteht, wobei mindestens ein Teil der Fluidauslässe der Sprenkleranlage oberhalb der Aufnahme für die zu testende Batterie positioniert ist, so dass freigesetztes Fluid mit einer Oberfläche der zu testenden Batterie direkt kontaktierbar ist,
das Fluid ein flüssiges Fluid umfasst oder daraus besteht und
das Fluid mindestens ein Bindemittel enthält oder daraus besteht, welches geeignet ist Säuren und/oder Basen zu binden.

2. Vorrichtung nach Anspruch 1, **dadurch gekennzeichnet, dass** das mindestens eine Bindemittel Kalziumoxid, Kalziumchlorid und/oder Kaliumhydroxid umfasst oder daraus besteht.

3. Vorrichtung nach Anspruch 1, **dadurch gekennzeichnet, dass** die Sprenkleranlage einen Fluidzulauf, einen oder mehrere Fluidauslässe und gegebenenfalls einen Fluidablass umfasst.

4. Vorrichtung nach einem der Ansprüche 1 bis 3, **dadurch gekennzeichnet, dass** einer oder mehrere der Fluidauslässe als Spülarm und/oder als Berieselungseinrichtung ausgebildet sind.

5. Vorrichtung nach einem der Ansprüche 1 bis 4, **dadurch gekennzeichnet, dass** die Sprenkleranlage mindestens eine Rückhaltewanne aufweist.

6. Vorrichtung nach einem der vorhergehenden Ansprüche, **dadurch gekennzeichnet, dass** die Batterieprüfkammer zusätzlich mindestens eine Anordnung zur Auslösung einer Belastung der zu testenden Batterie und/oder eine Sensorik zur Erfassung von Batteriezuständen aufweist.

7. Vorrichtung nach einem der vorhergehenden Ansprüche, **dadurch gekennzeichnet, dass** die Vorichtung zusätzlich eine oder mehrere PLC-Steuerungen aufweist, zur Steuerung der Mittel zum Binden von Schadstoffen.

## Claims

1. Apparatus for safely testing batteries, comprising a battery testing chamber having an interior space containing a receptacle for the battery which is to be tested, wherein the apparatus has at least one means for binding harmful substances, which means is designed in such a way that harmful substances which are released during testing of a battery in the battery testing chamber can be bound by a fluid,
**characterized in that**
the means for binding harmful substances comprises or consists of a sprinkler system, wherein at least some of the fluid outlets of the sprinkler system are positioned outside the receptacle for the battery which is to be tested, so that a surface of the battery which is to be tested can make direct contact with released fluid,
the fluid comprises or consists of a liquid fluid, and the fluid contains or consists of at least one binder which is suitable for binding acids and/or bases.

2. Apparatus according to Claim 1, **characterized in that** the at least one binder comprises or consists of calcium oxide, calcium chloride and/or potassium hydroxide.

3. Apparatus according to Claim 1, **characterized in that** the sprinkler system comprises a fluid inlet, one or more fluid outlets and possibly a fluid discharge.

4. Apparatus according to one of Claims 1 to 3, **characterized in that** one or more of the fluid outlets is in the form of a wash arm and/or in the form of a sprinkling device.

5. Apparatus according to one of Claims 1 to 4, **characterized in that** the sprinkler system has at least one reserve tub.

6. Apparatus according to one of the preceding claims, **characterized in that** the battery testing chamber additionally has at least one arrangement for tripping loading of the battery which is to be tested and/or a sensor system for detecting battery states.

7. Apparatus according to one of the preceding claims, **characterized in that** the apparatus additionally has one or more PLC controllers for controlling the means for binding harmful substances.

## Revendications

1. Dispositif de test sécurisé de batteries, comprenant une chambre d'essai de batterie dotée d'un espace intérieur contenant un logement pour la batterie à tester, le dispositif possédant au moins un moyen pour lier les substances nocives, lequel est réalisé de telle sorte que les substances nocives qui sont libérées pendant un test de batterie dans la chambre d'essai de batterie peuvent être liées par un fluide,
**caractérisé en ce que**
le moyen pour lier les substances nocives comprend ou se compose d'un équipement d'arrosage, au moins une partie des sorties de fluide de l'équipement d'arrosage étant positionnée au-dessus du logement pour la batterie à tester, de sorte que le fluide libéré puisse entrer en contact direct avec une surface de la batterie à tester,
le fluide comprend ou se compose d'un fluide liquide et le fluide contient ou se compose d'au moins un liant qui convient pour lier les acides et/ou les bases.

2. Dispositif selon la revendication 1, **caractérisé en ce que** l'au moins un liant comprend ou se compose d'oxyde de calcium, de chlorure de calcium et/ou d'hydroxyde de potassium.

3. Dispositif selon la revendication 1, **caractérisé en ce que** l'équipement d'arrosage comprend une arrivée de fluide, une ou plusieurs sorties de fluide et éventuellement un écoulement de fluide.

4. Dispositif selon l'une des revendications 1 à 3, **caractérisé en ce qu'**une ou plusieurs des sorties de fluide sont réalisées sous la forme de bras de pulvérisation et/ou d'appareils d'arrosage.

5. Dispositif selon l'une des revendications 1 à 4, **caractérisé en ce que** l'équipement d'arrosage possède au moins un bac de retenue.

6. Dispositif selon l'une des revendications précédentes, **caractérisé en ce que** la chambre d'essai de batterie possède en plus au moins un arrangement destiné à déclencher une sollicitation de la batterie à tester et/ou un arrangement de détection destiné à relever des états de la batterie.

7. Dispositif selon l'une des revendications précédentes, **caractérisé en ce que** le dispositif possède en plus une ou plusieurs commandes à API destinées à commander le moyen pour lier les substances nocives.
